# EUROPEAN PATENT APPLICATION

(11) **EP 2 120 525 A1**
(43) Date of publication of application: **18.11.2009**
(21) Application number: 08721360.9
(22) Date of filing: 05.03.2008
(51) Int. Cl.: H05K 9/00, B32B 15/08, E04B 1/92, G09F 9/00

(54) **LIGHT-TRANSMITTING ELECTROMAGNETIC SHIELDING MATERIAL, METHOD FOR PRODUCING THE SAME, AND FINE PARTICLE HAVING ULTRATHIN FILM OF NOBLE METAL**

(30) Priority: 05.03.2007 JP 2007054248
(71) Applicant: Bridgestone Corporation, Tokyo 104-0031 (JP)
(72) Inventor: KOTSUBO, Hidefumi, Kodaira-Shi Tokyo 187-8531 (JP); FUNAKI, Tatsuya, Kodaira-Shi Tokyo 187-8531 (JP); SASAKI, Kiyomi, Kodaira-Shi Tokyo 187-8531 (JP); HANZAWA, Kentaro, Kodaira-Shi Tokyo 187-8531 (JP)
(74) Representative: Whalley, Kevin
(86) International application number: PCT/JP2008/053940
(87) International publication number: WO 2008/108400

(57) **Abstract**

The present invention provides a process for efficiently preparing a light transmissive electromagnetic wave shielding material enhanced in light transmissive property, electromagnetic wave shielding property, appearance and legibility, and having high-accuracy mesh-pattern. The process for the preparation of a light transmissive electromagnetic wave shielding material comprising; printing in the form of mesh a pretreatment agent for electroless plating on a transparent substrate to form a mesh-shaped pretreatment layer, the pretreatment agent comprising a fine particle having an extremely-thin film of noble metal on its surface, and subjecting the mesh-shaped pretreatment layer to electroless plating to form a mesh-shaped metal conductive layer on the pretreatment layer.

## Description

### 1. Field of the invention

The present invention relates to a process for the preparation of a light transmissive electromagnetic wave shielding material which is useful in an adhesive sheet which can be used for a front filter of a plasma display panel (PDP) or windows of a building such as a hospital requiring electromagnetic wave shielding. Further, the invention relates to an electromagnetic wave shielding material advantageously prepared by the above process, and a fine particle having an extremely-thin noble metal film advantageously used in the process for the preparation of a light transmissive electromagnetic wave shielding material.

### 2. Description of the Related Art

In recent years, as office automation equipments and communication equipments have become increasingly popular, there is fear that an electromagnetic wave generated by the equipments has an affect on the human body. Further, the electromagnetic wave generated by a cell-phone may cause a precision equipment to malfunction. Therefore, the occurrence of the electromagnetic wave is of a problem to be solved.

For the reason, a light transmissive electromagnetic wave shielding material having a light transmissive property and an electromagnetic wave shielding property has been developed as a front filter of a plasma display panel and are put to practical use. Also the light transmissive electromagnetic wave shielding material is used as a window filter of a hospital and a laboratory where the precision equipment is installed in order to protect the equipment from the electromagnetic wave.

The light transmissive electromagnetic wave shielding material is required to balance the light transmissive property with the electromagnetic wave shielding property. Therefore, the light transmissive electromagnetic wave shielding material consists of, for example, (1) a conductive mesh comprising a transparent substrate and a conductive layer having a network-patterned structure made of metal line (wire) or conductive fiber provided on the one side of the substrate. The mesh part of the conductive layer enables shielding of electromagnetic wave and the opening part ensures light transmissive property.

In addition to the above-mentioned light transmissive electromagnetic wave shielding material, various transmissive electromagnetic wave shielding materials as a filter for electronic display are proposed. Examples of the transmissive electromagnetic wave shielding light materials generally include (2) a transparent substrate having a metallic silver-containing transparent conductive thin layer thereon; (3) a transparent substrate having network-patterned copper foil layer obtained by etching-processing copper foil so as to have opening parts thereon; (4) a transparent substrate having a mesh-shaped conductive ink layer containing conductive particles formed by printing thereon.

In order to balance the light transmissive property with the electromagnetic wave shielding property in the light transmissive electromagnetic wave shielding material, it is required to greatly reduce the line width to form an extremely fine pattern. However, it has been difficult to balance the light transmissive property with the electromagnetic wave shielding property. In more detail, the conductive mesh (1) has problems that it is difficult to greatly reduce the line width to form an extremely fine pattern and that arrangement of the fiber is distorted by deviation and twisting of mesh. In the light transmissive electromagnetic wave shielding material (2), electromagnetic wave shielding property cannot be satisfactily obtained and reflective brilliance is highly brought about due to metal. In case of the light transmissive electromagnetic wave shielding material (3), the production requires a long time period to bring about increased cost and light transmittance is reduced because of an adhesive layer provided between the transparent substrate and the silver foil. Further, in the light transmissive electromagnetic wave shielding material (4), it is difficult to obtain excellent electromagnetic wave shielding property because increase of thickness of the pattern to increase the amount of conductive particle, which enhances the electromagnetic wave shielding property, brings about reduction of light transmissive property.

The light transmissive electromagnetic wave shielding material (4) is prepared, for example, by printing a conductive ink comprising a conductive powder such as metal powder or carbon powder and resin on a transparent substrate by an engraved plate offset printing method to form a printing pattern. Therefore, the preparation does not require troublesome processing such as etching processing and hence the electromagnetic wave shielding material (4) can be advantageously prepared by a simple process and in reduced cost.

As improvement processes of the above-mentioned preparation (4), Patent Documents 1 to 6 describe a process for the preparation of an electromagnetic wave shielding material comprising printing a conductive ink on a transparent substrate by an engraved plate offset printing method to form a printing pattern and subsequently forming selectively a metal layer on the printing pattern by electroless plating or electrolytic plating in order to further enhance electromagnetic wave shielding property.

Moreover, Patent Document 7 describes a process for the preparation of an electromagnetic wave shielding material comprising printing a paste containing a supported particle in the form of pattern on a transparent substrate, the supported particle being obtained by applying a noble metal extremely-fine particle catalyst on a particle having charge opposite to the catalyst, and subsequently subjecting the noble metal extremely-fine particle catalyst printed in the form of pattern to electroless plating whereby a metal layer is formed only on the printing pattern.

Patent Document 1: Japanese Patent No. 3017987
Patent Document 2: Japanese Patent No. 3017988
Patent Document 3: Japanese Patent No. 3241348
Patent Document 4: Japanese Patent No. 3425400
Patent Document 5: Japanese Patent No. 3544498
Patent Document 6: Japanese Patent No. 3532146
Patent Document 7: Japanese Patent No. 3363083

### Disclosure of the Invention

### Problem to be solved by the Invention

The process comprising subjecting the noble metal extremely-fine particle catalyst printed in the form of pattern to electroless plating whereby a metal layer is formed only on the printing pattern, which is described in Patent Document 7, is advantageous in rapid formation of the metal layer owing to use of the noble metal catalyst. This fine particle is obtained by attaching the noble metal extremely-fine particle catalyst to a surface of a particle such as silica. The study of the present inventors has revealed that the fine particle does not sufficiently and efficiently show its catalytic action because the noble metal is in the form of particle.

Accordingly, the object of the present invention is to provide a process for efficiently preparing a light transmissive electromagnetic wave shielding material enhanced in light transmissive property, electromagnetic wave shielding property, appearance and legibility, and having high-accuracy mesh-pattern.

Further, the object of the present invention is to provide a light transmissive electromagnetic wave shielding material enhanced in light transmissive property, electromagnetic wave shielding property, appearance and legibility, and having high-accuracy mesh-pattern and high productivity.

Furthermore the object of the present invention is to provide a process for preparing a fine particle having an extremely-thin noble metal film which can be advantageously used in the preparation of the light transmissive electromagnetic wave shielding material mentioned above.

Furthermore the object of the present invention is to provide a fine particle having an extremely-thin noble metal film which can be advantageously used in the preparation of the light transmissive electromagnetic wave shielding material mentioned above.

### Means for solving problem

Thus, the present invention can be provided by a process for the preparation of a light transmissive electromagnetic wave shielding material comprising;
printing in the form of mesh a pretreatment agent for electroless plating on a transparent substrate to form a mesh-shaped pretreatment layer, the pretreatment agent comprising a fine particle having an extremely-thin film of noble metal on its surface, and
subjecting the mesh-shaped pretreatment layer to electroless plating to form a metal conductive layer on the pretreatment layer. The metal conductive layer naturally is a mesh-shaped metal conductive layer.

The embodiments of the process for the preparation of a light transmissive electromagnetic wave shielding material according to the present invention are described as follows:
(1) The extremely-thin film of noble metal has a thickness of 10 to 100nm. Thereby, even the use of a small amount of noble metal enables a forming rate of electroless plating to maximize. The extremely-thin film may contain not only noble metal but also a noble metal compound (e.g., chloride) in part.
(2) The extremely-thin film of noble metal comprises a monomolecular film of noble metal. Thereby, even the use of an extremely small amount of noble metal enables a forming rate of electroless plating to maximize.
(3) The fine particle is an organic resin fine particle. For example, in case an inorganic fine particle described in Patent Document 7 is used in a printing process, it is necessary to use equipments such as roll of the printer having high hardness because the inorganic fine particle is hard. Therefore the use of the inorganic fine particle reduces the processing margin, and further the equipments are apt to suffer damage due to the hard particle whereby the resultant printed material shows poor appearance. Thus, the use of the organic resin particle brings about enhancement of processing margin, workability and productivity. Moreover, the organic resin particle has lower specific gravity compared with the inorganic particle, and hence the particle scarcely causes precipitation or aggregation during printing or storing of the pretreatment agent containing the particle.
(4) The organic resin fine particle is a particle of phenol resin, amino resin, polyester resin, melamine resin, epoxy resin, divinylbenzene polymer, styrene/divinylbenzene copolymer, acrylic resin or styrene/(meth)acrylate copolymer. Preferred are acrylic resin (e.g., polymer or copolymer of alkyl (meth)acrylate), styrene/(meth)acrylate copolymer.
(5) The organic resin of the organic resin fine particle is crosslinked.
(6) The fine particle has mean particle size of 0.01 to 10 µm, preferably 0.05 to 3 µm, especially 0.1 to 1 µm. Thereby the line width of the mesh can be reduced.
(7) The pretreatment agent further contains synthetic resin. Thereby the dispersibility of the fine particle can be enhanced.
(8) The noble metal is at least one metal selected from the group consisting of palladium, silver, platinum and gold.
(9) The fine particle having an extremely-thin film of noble metal thereon is obtained by treating the fine particle with a solution containing noble metal chloride and tin chloride, and subjecting the treated fine particle to reduction treatment (acid treatment).
(10) The fine particle having an extremely-thin film of noble metal thereon is obtained by treating the fine particle with a solution comprising a noble metal compound and a mixture of a silane coupling agent and an azole compound or a reaction product thereof.
   The silane coupling agent preferably is an epoxy-containing silane compound, which brings about high catalytic activity and excellent adhesion. The azole compound preferably is imidazole, which is excellent in reactivities with a functional group such as an epoxy group of the silane coupling agent and with the noble metal compound.
(11) The present process further comprises drying the transparent substrate on which the pretreatment agent has been printed at 80 to 160°C, whereby the pretreatment layer having fine pattern can be easily obtained.
(12) Metal used in the electroless plating is silver, copper or aluminum, whereby electromagnetic shielding property of the metal conductive layer can be enhanced.
(13) After the electroless plating is carried out, further electrolytic plating is done, whereby a metal conductive layer having a desired thickness can be obtained.
(14) The process further comprises subjecting the metal conductive layer to a blackening treatment to form a blackening treatment layer on at least one part of a surface of the metal conductive layer.
(15) The blackening treatment is carried out by oxidation or sulfurization treatment of the metal conductive layer. The blackening treatment provides the metal conductive layer with antiglare property to enhance legibility.

Further, the present invention can be provided by a light transmissive electromagnetic wave shielding material comprising a transparent substrate, a mesh-shaped pretreatment layer provided thereon, and a mesh-shaped metal conductive layer provided on the pretreatment layer,
wherein the pretreatment layer comprises a fine particle having an extremely-thin film of noble metal on its surface.

[0018] The preferred embodiments of the process for the preparation of a light transmissive electromagnetic wave shielding material as mentioned previously can be applied to the light transmissive electromagnetic wave shielding material.

Furthermore, the present invention can be provided by a fine particle (preferably organic resin fine particle) having an extremely-thin film of noble metal on its surface.

The preferred embodiments of the process for the preparation of a light transmissive electromagnetic wave shielding material as mentioned previously can be applied to the fine particle provided that the embodiments are concerned with the fine particle.

The fine particle having an extremely-thin film of noble metal thereon can be advantageously obtained by a process comprising treating a fine particle with a solution containing noble metal chloride and tin chloride, and subjecting the treated fine particle to reduction treatment (e.g., acid treatment); or
a process comprising treating a fine particle with a solution comprising a noble metal compound and a mixture of a silane coupling agent and an azole compound or a reaction product thereof.

The embodiments of the process are described as follows:
(1) The silane coupling agent is an epoxy-containing silane compound, which brings about high catalytic activity and excellent adhesion.
(2) The azole compound is imidazole, which is excellent in reactivities with a functional group such as an epoxy group of the silane coupling agent and with the noble metal compound.
(3) The fine particle is an organic resin fine particle.

The preferred embodiments of the process for the preparation of a light transmissive electromagnetic wave shielding material as mentioned previously can be applied to the process provided that the embodiments are concerned with a process for the preparation of the fine particle.

### Effect of the Invention

According to the present invention, the pretreatment agent comprising a fine particle having an extremely-thin film of noble metal on its surface is used in order to form a metal conductive layer on a transparent substrate, and hence the resultant metal conductive layer has an accurate fine pattern including a uniform thickness. Further, since the fine particle having an extremely-thin film of noble metal, which is formed by adsorption of noble metal to the surface of the fine particle, is used as a noble metal catalyst, the resultant pretreatment layer containing the fine particle shows maximum catalytic effect by using extremely small amount of noble metal and therefore the electroless plating can be carried out rapidly and uniformly.

Particularly, in case an organic resin fine particle is used as the fine particle, it is unnecessary to use equipments such as roll of the printer having high hardness because it is not as hard as the inorganic fine particle, and further increased processing margin is obtained and the equipments scarcely suffer damage due to the soft particle whereby the resultant printed material shows good appearance.
Thus, the use of the organic resin particle brings about enhancement of processing margin, workability and productivity. Further, the organic resin particle has lower specific gravity compared with the inorganic particle, and hence the particle scarcely causes precipitation or aggregation during printing or storing of the pretreatment agent containing the particle.

Moreover, in case the pretreatment agent combines the noble metal catalyst (the fine particle) with a silane coupling agent and an azole compound, the noble metal is apt to easily disperse at atomic level and the reduction treatment and the like can be omitted. Therefore the electroless plating can be carried out more rapidly and uniformly, and is free from occurrence of streak or fog.

Thus the present invention enables the provision of a light transmissive electromagnetic wave shielding material enhanced in light transmissive property, electromagnetic wave shielding property, appearance and legibility.

### Brief Description of the Drawings

Fig. 1 is a schematic cross-section view for explaining the process for preparing the light transmissive electromagnetic wave shielding material according to the present invention.
Fig. 2 is a schematic cross-section view of the fine particle having an extremely-thin film of noble metal used in the process for preparing the light transmissive electromagnetic wave shielding material according to the present invention.
Fig. 3 is an enlarged schematic cross-section view of the pretreatment layer provided on the transparent substrate according to the present invention.
Fig. 4 is a view showing an example of the pattern of the pretreatment layer.

### Description of the reference numbers

- 11:: Transparent substrate
- 12, 22:: Mesh-shaped pretreatment layer
- 13:: Mesh-shaped metal conductive layer
- 14:: Blackening treatment layer
- 16:: Fine particle
- 17:: Extremely-thin noble metal layer
- 25:: Opening part

### Detailed Description of the Invention

The light transmissive electromagnetic wave shielding material and the process for the preparation thereof are explained in detail below.

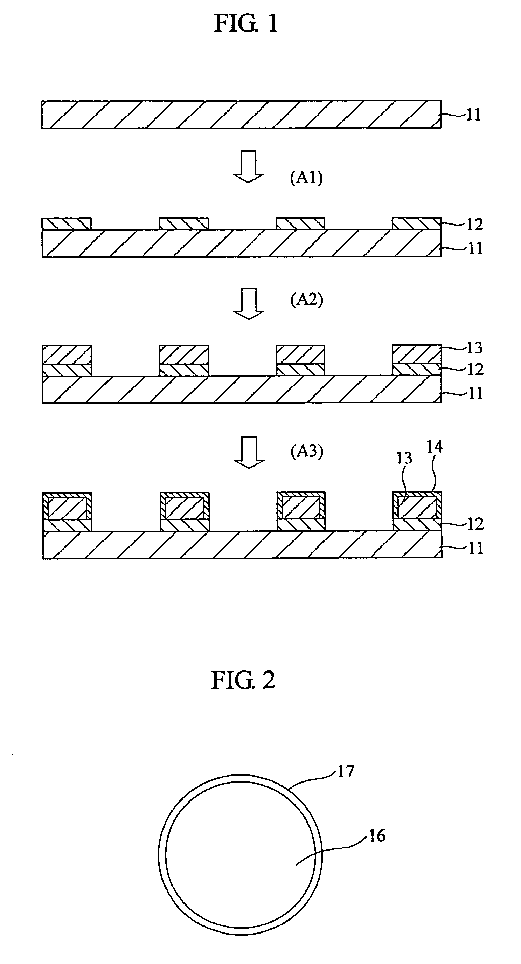

Fig. 1 is an example of a schematic cross-section view for explaining each of the steps of the process of the present invention.

In the process for preparing the light transmissive electromagnetic wave shielding material of the present invention, first, a pretreatment agent comprising a fine particle having an extremely-thin film of noble metal on its surface is coated in the form of mesh on a transparent substrate 11 to form a pretreatment layer 12 on the transparent substrate 11 (an arrow (A1) of Fig. 1). Subsequently, the transparent substrate 11 having the mesh-shaped pretreatment layer 12 is subjected to electroless plating to form a metal conductive layer 13 on the pretreatment layer 12 (an arrow (A2) of Fig. 1). In more detail, the metal conductive layer 13 is provided on the pretreatment layer 12 which is formed by using the fine particle having an extremely-thin film of noble metal, such that fine metal particles forming for the metal conductive layer 13 are deposited and attached in high concentration to each other to form substantial continuous film, whereby the metal conductive layer 13 having fine pattern can be obtained. Then, the metal conductive layer 13 is subjected to blackening treatment to form the blackening treatment layer 14 on at least part of the metal conductive layer 13 (an arrow (A3) of Fig. 1). It may not be necessary to carry out the blackening treatment if not desired depending on uses.

In the process of the invention, the pretreatment agent comprising a fine particle having an extremely-thin film of noble metal on its surface is used as a pretreatment agent for electroless plating. A schematic cross-section view of the fine particle having an extremely-thin film of noble metal is shown in Fig. 2. An extremely-thin film 17 of noble metal atom is formed on a surface of a fine particle 16. Generally, the film 17 is a monomolecular film formed by the adsorption of the noble metal atoms to the particle and the tight linking of the adsorbed noble metal atoms to each other. The extremely-thin film 17 includes a monomolecular film or a thin film including a monomolecular film. Therefore the extremely-thin film 17 generally has a (mean) thickness of 10 to 100 nm. These noble metal atoms are not in the form of particle, and hence they are considered to show efficiently the catalytic action. It is considered that noble metal atoms inside a particle of a particle-shaped catalyst do not exert catalytic action whereby the catalytic effect is reduced. The extremely-thin film 17 may contain complexes (e.g., Pd-Sn) which are not converted to noble metal.

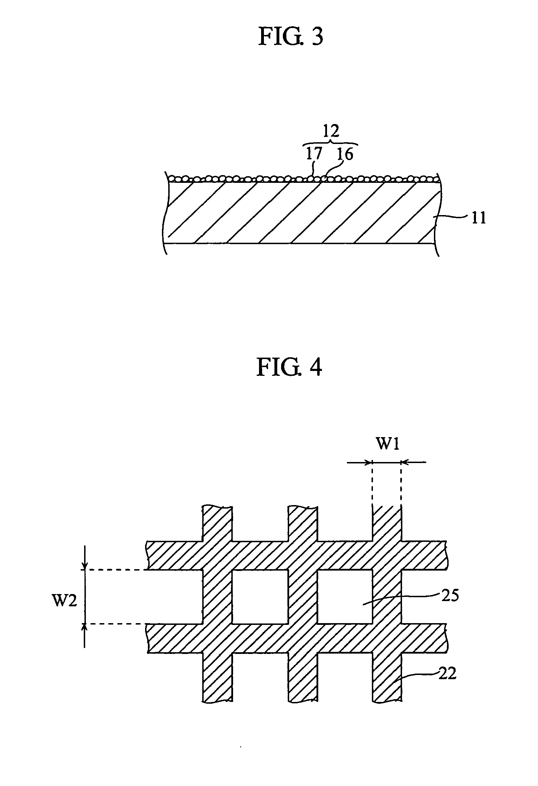

Further, the pretreatment layer 12 of the invention is provided as shown in Fig. 3 which explains the layer in detail. The pretreatment layer 12 comprising fine particles 16 having an extremely-thin film 17 of noble metal on its surface is formed on the transparent substrate 11. The fine particles are continuously and tightly linked to each other, and therefore the metal conductive layer formed on the linked fine particles also becomes a uniform film. The use of a synthetic resin as a binder mainly brings about enhancements of adhesion between the pretreatment layer and transparent substrate and linking between the particles.

The fine particle having an extremely-thin film of noble metal thereon used in the preparation of the pretreatment layer can be obtained, for example, by a process comprising treating a fine particle with a solution containing noble metal chloride and tin chloride, and subjecting the treated fine particle to reduction treatment (e.g., acid treatment); or a process comprising treating a fine particle with a solution comprising a noble metal compound and a mixture of silane coupling agent and azole compound or a reaction product thereof. Particularly, in case the fine particle obtained from the latter process is used, it is easy to arrange the noble metal uniformly on the surface of a fine particle, and therefore the catalytic effect for metal deposition in electroless plating can be maximized. Further, the pretreatment layer formed by using the pretreatment agent for electroless plating is improved in adhesion between the transparent substrate and metal conductive layer due to use of the silane coupling agent and azole compound.

In the arrow (A2) of Fig. 1, the metal conductive layer 13 is formed on the pretreatment layer 12 through electroless plating as mentioned above. Thereby, the fine metal particles are selectively attached onto the pretreatment layer to form a substantially continuous concentrated film, whereby the metal conductive layer having fine pattern can be obtained.

As mentioned above, the metal conductive layer having fine pattern can be rapidly prepared by the process of the invention, and hence it is possible to prepare the light transmissive electromagnetic wave shielding material improved in both of light transmissive property and electromagnetic wave shielding property.

Materials used in the light transmissive electromagnetic wave shielding material of the present invention are explained in detail below.

A fine particle for the preparation of the fine particle having an extremely-thin film of noble metal includes an inorganic particle and an organic particle. The organic particle, particularly an organic resin particle is preferred. Examples of the inorganic particle include inorganic pigments such as silica, alumina, alumina aerosol, clay, kaolin, talc, calcium sulfate, calcium carbonate, and glass flake. Examples of the organic resin of the organic resin particle include phenol resin, amino resin, polyester resin, melamine resin, epoxy resin, divinylbenzene polymer, styrene/divinylbenzene copolymer, acrylic resin or styrene/(meth)acrylate copolymer. Preferred are acrylic resin (e.g., polymer or copolymer of (meth)acrylate such as alkyl (meth)acrylate), styrene/(meth)acrylate copolymer. The organic resin of the organic resin particle is preferably cured. For example, the acrylic resin is cured by using polyfunctional (meth)acrylate or polyisocyanate. Further, the organic resin may have a functional group such as OH group on its surface, whereby noble metal atoms easily adsorb to the particle to form an extremely thin film,

The fine particle has mean particle size of 0.01 to 10 µm, preferably 0.05 to 3 µm, especially 0.1 to 1 µm. Thereby the line width of the mesh can be reduced.

The noble metal preferably is palladium, silver, platinum and/or gold, particularly palladium (Pd).

The fine particle having an extremely-thin film of noble metal thereon is obtained, for example, in the following manner.

First, the fine particle is subjected to alkali degreasing treatment, and subsequently neutralized with acid. The treated fine particle is treated as below.

1) The treated fine particle is treated with tin chloride whereby its surface is sensitized, and subsequently the fine particle is treated with palladium chloride and activated to generate metal palladium (method 1).
2) The treated fine particle is treated with a solution of tin chloride and palladium chloride to generate Pd-Sn complex (catalyst) and subjected to reduction treatment using hydrochloric acid or the like, and this oxidation-reduction reaction cause metal palladium to generate ((accelerator) method 2).
3) The fine particle is treated with a solution comprising palladium chloride (noble metal compound), and a mixture of a silane coupling agent and an azole compound or a reaction product thereof (method 3).

The methods 2 and 3 are preferred, particularly the method 3.

Examples of a reducing agent used in the reduction treatment of the noble metal ion of the method 2 include inorganic salts or compounds thereof such as sodium borohydride, inorganic acids such as hydrochloric acid, organic acids having 1-6 carbon atoms such as formic acid, acetic acid and citric acid, aldehydes having 1-2 carbon atoms such as formaldehyde and acetoaldehyde, alcohols having 1-3 carbon atoms such as methanol, ethanol and propanol, and reducing gases such as hydrogen, ethylene and carbon monoxide. In order to extremely reduce the thickness of the noble metal film, it is preferred to use the inorganic acids such as hydrochloric acid as the reducing agent.

The silane coupling agent used in the treatment solution for the preparation of the fine particle having an extremely-thin noble metal film of the method 3 preferably has a functional group having metal capture capability, and the silane coupling agent having the functional group causes the noble metal as an electroless plating catalyst to be in the electron and orientation conditions for efficiently exerting the activity of the noble metal. Further the adhesion to the transparent substrate is also enhanced.

The silane coupling agent includes an epoxy-containing silane compound. Examples of the epoxy-containing silane compound include γ-glycidoxypropyltrialkoxysilane, 3-glycidoxypropyltrimethoxysilane, 3-glycidoxypropylmethyl dimethoxysilane, 3-glycidoxypropyltriethoxysilane, 3-glycidoxypropylmethyldiethoxysilane and 2-(3,4-epoxycyclohexyl)ethyltrimethoxysilane. These can be used singly, or in combination of two more kinds. The γ-glycidoxypropyltrialkoxysilane is particularly preferred, because it gives a high light transmissive property to the resultant pretreatment layer.

Examples of the azole compounds used in the treatment solution for the preparation of the fine particle having an extremely-thin noble metal film include imidazole, oxazole, thiazole, selenazole, pyrazole, isooxazole, isothiazole, triazole, oxadiazole, thiadiazole, tetrazole, oxatriazole, thiatriazole, bendazole, indoazole, benzimidazole, benzotriazole and indazole. The imidazole is particularly preferred, because it has high reactivities to the groups of the silane coupling agent such as epoxy group and to the noble metal compound.

In the treatment solution for the preparation of the fine particle having an extremely-thin noble metal film of the method 3, though the silane coupling agent and the azole compound are simply mixed with each other, these may be preliminarily reacted with each other to form the reaction product thereof. The reaction product enables the noble metal compound in the pretreatment layer to highly disperse at the atomic level, whereby the light transmissive property of the resultant pretreatment layer can be improved.

In the reaction of the silane coupling agent with the azole compound, it is preferred to mix the silane coupling agent in an amount of 0.1 to 10 mole per a mole of the azole compound with the azole compound and react the mixture at a temperature of 80 to 200 °C for a period of 5 minutes to 2 hours. Though the solvent is unnecessary in the reaction, it is possible to use as the solvent water, an organic solvent such as chloroform, dioxane-methanol and ethanol. The treatment solution can be obtained by mixing the resultant reaction product of the silane coupling agent and the azole compound with the noble metal compound.

The noble metal compound used in the treatment solution for the preparation of the fine particle having an extremely-thin noble metal film is capable of selectivity precipitating and developing the metal (e.g., copper and aluminum) from the plating solution in the electroless plating treatment. The noble metal compounds containing metal atom(s) such as palladium, silver, platinum and/or gold are preferably used, because of their high catalytic activity. Examples of the compounds include chlorides, hydroxides, oxides, sulfates and ammine complexes (e.g., ammonium salts) of the above metals. The palladium compounds, particularly the palladium chloride(s) are preferred.

The treatment solution for the preparation of the fine particle having an extremely-thin noble metal film of the method 3, contains the noble metal compound in the amount of preferably 0.001 to 50 mol%, more preferably 0.1 to 20 mol% based on the total amount of the azole compound and silane coupling agent. When the amount of the noble metal compound is less than 0.001 mol%, the catalyst activity is not apt to be high enough to form the metal conductive layer having sufficient thickness. When the amount of the noble metal compound is more than 50 mol%, the catalyst activity of the noble metal compound is not apt to increase with the increase of the addition amount.

The treatment solution for the preparation of the fine particle having an extremely-thin noble metal film may contain appropriate solvents. Examples of the solvents include water, methyl alcohol, ethyl alcohol, 2-propanol, acetone, toluene, ethylene glycol, polyethylene glycol, dimethyl formamide, dimethyl sulfoxide and dioxane. These solvents can be used singly or in combination of two or mo re kinds.

The pretreatment agent for electroless plating of the invention comprises the fine particle having an extremely-thin noble metal film, and if necessary, synthetic resin, solvent, and further if necessary, additives such as extender pigment, surfactant and colorant.

As the synthetic resins for the pretreatment agent for electroless plating, any synthetic resins can be used as long as the synthetic resin adhere firmly to the transparent substrate and the metal conductive layer. Preferred examples of the synthetic resins include acrylic resin, polyester resin, polyurethane resin, vinyl chloride resin and ethylene/vinyl acetate copolymer. The use of these resins brings about excellent adhesion to the transparent substrate and the metal conductive layer, and accuracy formation of the metal conductive layer on the pretreatment layer. These synthetic resins can be used singly or in combination of two or mo re kinds.

As the acrylic resin, homopolymers or copolymers of, for example alkyl acrylate esters such as methyl acrylate, ethyl acrylate, butyl acrylate and hexyl acrylate; alkyl methacrylate esters such as methyl methacrylate, ethyl methacrylate, butyl methacrylate and hexyl methacrylate can be used. For example, polymethylmethacrylate, polyethylmethacrylate or polybutylmethacrylate are preferred.

Examples of the polyester resins include polyethylene terephthalate, polybuthylene terephthalate, polytrimethylene terephthalate and 2,6-polyethylene naphthalate.

The synthetic resins preferably have a functional group having active hydrogen at the end of its molecule because they have improved adhesion. Examples of the functional group having active hydrogen include a primary amino group, a secondary amino group, an imino group, an amido group, a hydrazide group, an amidino group, an imido group, a hydroxy group, a hydroperoxy group, a carboxyl group, a formyl group, a carbamoyl group, a sulfonic acid group, a sulfinic acid group, a sulfenic acid group, a thiol group, a thioformyl group, a pyrrolyl group, an imidazolyl group, a piperidyl group, an indazolyl group and a carbazolyl group. Preferred are a primary amino group, a secondary amino group, an imino group, an amido group, an imido group, a hydroxy group, a formyl group, a carboxyl group, a sulfonic acid group and a thiol group. Particularly preferred are a primary amino group, a secondary amino group, an amido group, and a hydroxy group. These groups may be substituted by a halogen atom or a hydrocarbon group having 1-20 carbon atoms. Further, an amino group and a hydroxy group are preferred.

The synthetic resin is preferably contained in the pretreatment agent for electroless plating in the amount of 1 to 50% by weight, particularly 5 to 20% by weight based on the total amount of the pretreatment agent. Thereby, a pretreatment layer showing improved adhesion can be formed.

The fine particle having an extremely-thin noble metal film is preferably contained in the pretreatment agent for electroless plating in the amount of 10 to 60% by weight, particularly 20 to 50% by weight based on the total amount of the pretreatment agent. Thereby, the electroless plating can be rapidly carried out.

The pretreatment agent for electroless plating may further contain an inorganic particle, which brings about enhancement of printing precision to enable the formation of an accurate metal conductive layer. Example of the inorganic particle include silica, calcium carbonate, carbon black, alumina, talc, mica, glass flake, metal whisker, ceramic whisker, calcium sulfate whisker, and smectite. These inorganic particles can be used singly or in combination of two or mo re kinds.

The inorganic particle has preferably a mean particle size of 0.01 to 5 µm, particularly 0.1 to 3 µm. The addition of the inorganic particle of less than 0.01 µm probably does not bring about desired printing precision, whereas the addition of the inorganic particle of more than 5 µm possibly brings about occurrence of streak or fog.

The inorganic particle is preferably contained in the pretreatment agent for electroless plating in the amount of 0.01 to 10 parts by weight, particularly 1 to 5 parts by weight based on 100 parts by weight of the synthetic resin. Thereby, the pretreatment agent has enhanced printability.

The pretreatment agent for electroless plating may further contain a thixotropic agent. The use of the thixotropic agent enables adjustment of flowability of the pretreatment agent to enhance printing precision, whereby further accurate metal conductive layer can be formed. Conventional thixotropic agents can be used. Preferred examples of the thixotropic agent include amide wax, hardened caster oil, beeswax, carnauba wax, stearic acid amide, and hydroxystearic acid ethylene bisamide.

The thixotropic agent is preferably contained in the pretreatment agent for electroless plating in the amount of 0.1 to 10 parts by weight, particularly 1 to 5 parts by weight based on 100 parts by weight of the synthetic resin. Thereby, the pretreatment agent has enhanced printability.

The pretreatment agent for electroless plating may further contain a black colorant. Thereby, the pretreatment agent has enhanced printing precision, and the resultant electromagnetic wave shielding material acquires good antiglare effect, the antiglare effect being measured by viewing the material from the side of the transparent substrate.

Examples of the black colorant include carbon black, titanium black, black iron oxide, graphite, and activated carbon. They may be used singly or in combination of two or more kinds. Carbon black is preferred. Examples of carbon black include acetylene black, channel carbon black and furnace carbon black. The carbon black preferably has mean particle size of 0.1 to 1,000nm, particularly 5 to 500nm.

The black colorant is preferably contained in the pretreatment agent for electroless plating in the amount of 0.1 to 10 parts by weight, particularly 1 to 5 parts by weight based on 100 parts by weight of the synthetic resin. Thereby, the pretreatment layer having antiglare effect can be accurately formed.

In case of using the black colorant, a commercially-supplied black ink containing the black colorant is preferably used for preparing the pretreatment agent for electroless plating. Examples of the black ink include SS8911 (Trade name) available from Toyo Ink MFG. Co., Ltd., EXG-3590 (Trade name) available from Jujo Chemical Co., Ltd., and NT-HILAMIC 759R Black (Trade name) available from Dainichiseika Color & Chemicals Mfg. Co., Ltd. For example, SS8911 of Toyo Ink MFG. Co., Ltd. include polyvinyl chloride and acrylic resin in addition to carbon black in a solvent. Therefore, the use of the commercially-supplied black ink facilitates the preparation of the pretreatment agent for electroless plating containing the black colorant.

Further the pretreatment agent for electroless plating may contain appropriate solvents. Examples of the solvents include water, methyl alcohol, ethyl alcohol, 2-propanol, acetone, toluene, ethylene glycol, polyethylene glycol, dimethyl formamide, dimethyl sulfoxide and dioxane. These solvents can be used singly or in combination of two or mo re kinds.

The pretreatment agent for electroless plating may contain further various additives such as an extender pigment, surfactant and colorant, if necessary.

In the present invention, any transparent substrate can be used as long as the transparent substrate coated with the pretreatment agent has a transparency and flexibility and withstand the subsequent steps. Examples of material of the transparent substrate includes glass, polyester (e.g., polyethylene terephthalate (PET), polybutylene terephthalate), acrylic resin (e.g., polymethylmethacrylate (PMMA)), polycarbonate (PC), polystyrene, cellulose triacetate, polyvinylalcohol, polyvinyl chloride, polyvinylidene chloride, polyethylene, ethylene-vinyl acetate copolymer, polyvinyl butyral, metal ion crosslinked ethylene-methacrylic acid copolymer, polyurethane and cellophane. Of them, PET, PC and PMMA are preferred, because these are less deteriorated by the processing treatments (heating, solvent and bending) and have an excellent transparency. The sheet, film and plate composed of the above materials can be used as the transparent substrate.

There is no limit of the thickness of the transparent substrate. However, the transparent substrate is preferably thin from a viewpoint of the light transmissive property of the light transmissive electrolytic shielding material. The thickness of the transparent substrate is generally set within the range of 0.05 to 5 mm depending on the configuration at the application and the desired mechanical strength.

In the process of the present invention, the above-mentioned pretreatment agent for electroless plating is printed in the form of mesh on the transparent substrate, whereby the mesh-shaped pretreatment layer is formed on the transparent substrate.

The viscosity of the pretreatment agent is preferably in the range of 500 to 5,000 cps, more preferably 1,000 to 3,000 cps at 25°C in order to form the pretreatment layer having fine line width and pitch by printing.

The pretreatment agent for electroless plating can be printed on the transparent substrate by a printing method such as a gravure printing, a screen printing, an offset lithography, an electrostatic printing or a flexo printing. From the viewpoint of forming a narrow line, the gravure printing is preferred. In case the gravure printing is used, the printing speed is preferably in the range of 5 to 50 m/minute.

Further, the pretreatment layer can be formed by transferring printing. In case the transferring printing is used, the pretreatment layer can be transferred by printing the pretreatment agent on a substrate sheet for transfer, which is different from the transparent substrate, through using the same printing method as above, and then combining the substrate sheet having the pretreatment layer with the transparent substrate by laminate heating, drying laminate, wet laminate or extrusion laminate, and then separating only the substrate sheet to form the pretreatment layer on the transparent substrate.

After the pretreatment agent for electroless plating is printed as above, the printed layer is preferably dried by heating at 80 to 160°C, particularly 90 to 130°C (particularly in case of using the method 3). The drying at less than 80°C possibly brings about insufficient film formation, whereas the drying at more than 160°C possibly brings about decomposition of the compound. The drying time period preferably is in the range of 5 seconds to 5 minutes.

Any shapes can be adopted as the shape of the pattern of the mesh-shaped pretreatment layer. Examples of the shapes include grid shape having quadrangular opening, and punching metal shape having circular, hexagonal, triangle or ellipsoidal opening. The openings can be regularly or randomly arranged.

From a viewpoint of providing high light transmissive property and high electromagnetic wave shielding property to the metal conductive layer, it is preferred to regularly arrange the openings of the pretreatment layer at even interval. Further in order to enhance high light transmissive property of the metal conductive layer, it is preferred to set the shape of the openings of the metal conductive layer to rectangular shape, especially square or oblong shape and to increase the opening ratio (aperture ratio). Hence, the size of the opening of the pretreatment layer is preferably reduced extremely. For example, Fig. 4 shows an example of the pattern of the pretreatment layer 12 having opening past 15 in the form of foursquare.

In the pretreatment layer of the invention, the line width (W₁) preferably is 1 to 50 µm, particularly 5 to 40 µm, and the opening ratio preferably is 50 to 95%, particularly 60 to 95%. The opening ratio (aperture ratio) of the pretreatment layer means the proportion of the area of the opening portion of the layer to the projected area of the layer. In case an outer frame is provided, the projected area of the layer corresponds to that after the removal of the outer frame. Further the line interval (W₂) of the pretreatment layer preferably is 50 to 1,000 µm, particularly 100 to 400 µm. According to the invention, the pretreatment layer having fine pattern can be accurately formed.

The pretreatment layer can be formed on the central portion of the transparent substrate except its surrounding portion, so that the mesh-shaped pattern is formed on the central part of the transparent substrate and the flame-shaped pattern can be formed on the surrounding portion of the central portion. In case the metal conductive layer is formed on the pretreatment layer having the above pattern, the mesh-shaped pattern of the metal conductive layer can be protected by the flame-shaped pattern.

The pretreatment layer preferably has a thickness of 0.01 to 2 µm, particularly 0.05 to 0.5 µm. Thereby enhanced adhesion between the transparent substrate and metal conductive layer can be ensured.

In the process of the invention, a conductive layer is subsequently formed on the pretreatment layer formed as above by electroless plating so as to have the mesh pattern. By the electroless plating, the fine metallic particles are deposited and attached in high concentration to each other to selectively form a substantial continuous film only on the pretreatment layer.

Any metals having conductive property and capable of being subjected to plating can be used as the plating metal. The plating metal is generally an elemental metal, an alloy, a conductive metal oxide, or fine particles coated uniformly by a metallic thin film.

Examples of the plating metals used in the electroless plating include aluminum, nickel, indium, chromium, gold, vanadium, tin, cadmium, silver, platinum, copper, titanium, cobalt and lead. In particular, silver, copper and aluminum are preferred, because its use brings about the metal conductive layer having high electromagnetic wave shielding property. The metal conductive layer formed by using the above metal has a high adhesion to the pretreatment layer and a plating protective layer, and is excellent in both of light permeation property and electromagnetic wave shielding property.

The electroless plating can be carried out at room temperature or under heating according to a known method using a electroless plating bath. For example, the electroless plating is carried out by immersing a material to be plated in the electroless plating solution comprising a plating metallic salt, a chelating agent, a pH adjuster and a reducing agent as basic constituents, or by separating a plating composition into not less than 2 parts and adding them.

For example, in case the metal conductive layer comprising copper are formed, the transparent substrate on which the pretreatment layer is formed is immersed in a solution comprising an aqueous copper salt such as copper sulfate in an amount of 1 to 100 g/L, particularly 5 to 50 g/L, a reduction agent such as formaldehyde in an amount of 0.5 to 10 g/L, particularly 1 to 5 g/L and a complexing agent such as EDTA in an amount of 20 to 100 g/L, particularly 30 to 70 g/L, and having pH in the range of 12 to 13.5, particularly 12.5 to 13, at temperature of 50 to 90°C for 30 seconds to 60 minutes.

During the electroless plating, the substrate to be plated can be vibrated and rotated. In addition, the area around the substrate can be stirred with air.

In the invention, after the transparent substrate having the pretreatment layer with desired thickness and line width is subjected to electroless plating, it is possible to further electrolytically plate the transparent substrate.

The plating metals used in the electroless plating can be also used in the electrolytic plating.

The electrolytic plating can be carried according to a known method. For example, the electrolytic plating is carried out by immersing the transparent substrate having the pretreatment layer and metal conductive layer in a plating solution and applying electrical current to the plating solution under the conditions of cathode of the transparent substrate and anode of plating metal. There is no limitation on the composition of the plating solution. For example, in case of forming a metal conductive layer comprising Cu, a aqueous solution of copper sulfate and the like are generally used.

Any shapes can be adopted as the shape of the pattern of the mesh-shaped metal conductive layer in the same manner as in the pretreatment layer.

In the metal conductive layer of the invention, the line width (W₁) preferably is 1 to 50 µm, particularly 5 to 40 µm, and the opening ratio preferably is 50 to 95%, particularly 60 to 95%, as described in Fig. 4. The opening ratio (aperture ratio) of the metal conductive layer means the proportion of the area of the opening portion of the layer to the projected area of the layer. In case an outer frame is provided, the projected area of the layer corresponds to that after the removal of the outer frame. Further the line interval (W₂) of the metal conductive layer preferably is 50 to 1,000 µm, particularly 100 to 400 µm. According to the invention, the metal conductive layer having fine pattern can be accurately formed.

As explained in the pretreatment layer, the metal conductive layer can be formed on the central portion of the transparent substrate except its surrounding portion, so that the mesh-shaped pattern is formed on the central portion of the transparent substrate and the flame-shaped pattern can be formed on the surrounding portion of the central portion.

The metal conductive layer preferably has a thickness of 1 to 200 µm, particularly 5 to 100 µm. The thickness over the lower limit possibly brings about insufficient electromagnetic wave shielding property whereas the thickness over the upper limit is disadvantage to prepare a thin electromagnetic wave shielding material.

In the present invention, as shown by the Fig 1, the metal conductive layer 13 can be subsequently subjected to a blackening treatment to form a blackening treatment layer 14 on at least part of the surface of the metal conductive layer 13 (an arrow (A3) of Fig. 1).

The blackening treatment is preferably carried out by subjecting the metal conductive layer to an oxidation treatment or a sulfurization treatment. In particular, the sulfurization treatment is preferably adopted for improving an anti-glare property and ensuring the simple waste liquid treatment and the environment safety.

In case the oxidation treatment is carried out as the blackening treatment, examples of the blackening treatment liquid used in the oxidation treatment include a mixed aqueous solution of a hypochlorite and a sodium hydroxide, a mixed aqueous solution of a chlorite and a sodium hydroxide and a mixed aqueous solution of a peroxodisulfuric acid and a sodium hydroxide. In particularly, from a viewpoint of economic efficiency, the mixed aqueous solution of the hypochlorite and the sodium hydroxide and the mixed aqueous solution of the chlorite and the sodium hydroxide are preferred.

In case the sulfurization treatment is carried out as the blackening treatment, examples of the blackening treatment liquid include aqueous solutions comprising, for example, a potassium sulfide, a barium sulfide and a ammonium sulfide, preferably the potassium sulfide and the ammonium sulfide. The ammonium sulfide is particularly preferred, because it can be used at low temperature.

The blackening treatment layer preferably has a thickness of 0.01 to 1 µm, particularly 0.01 to 0.5 µm, though it is not particularly restricted. The thickness of less than 0.01 µm possibly bring about insufficient anti-glare effect against light, whereas the thickness of more than 1 µm possibly reduces the cosmetic opening ratio, which is measured by viewing obliquely the material.

According to the present invention, the use of the pretreatment agent for electroless plating comprising a fine particle having an extremely-thin noble metal film enables accurate and rapid preparation of the metal conductive layer having fine pattern, and preparation of the light transmissive electromagnetic wave shielding material enhanced in light transmissive property, electromagnetic wave shielding property, appearance and legibility.

The light transmissive electromagnetic wave shielding material of the invention has high light transmissive property due to the use of the specific pretreatment agent for electroless plating. Therefore the light transmissive electromagnetic wave shielding material generally has total light transmittance of not less than 75%, particularly 80 to 90% because the provision of the pretreatment layer does not bring about the reduction of the transmittance.

A total light transmittance of the light transmissive electromagnetic wave shielding material can be determined by measuring the total light transmittance in the direction of the thickness of the light transmissive electromagnetic wave shielding material by means of a full automatic Digital Haze Computer HGM-2DP manufactured by Suga Test Instrument Co., Ltd.

The light transmissive electromagnetic wave shielding material of the invention preferably can be used in applications requiring the light transmissive property, for example, display surface of display devices, which may generate the electromagnetic wave, such as LCD, PDP and CRT, and a surface of transparent glass and transparent panel of facilities and building. It is preferable to use the light transmissive electromagnetic wave shielding material as a display filter for the display device, because it has an enhanced light transmissive property and electromagnetic wave shielding property.

The light transmissive electromagnetic wave shielding material of the invention is directly used as an optical filter for display. However, for example, the optical filter can be prepared by attaching the material onto a surface of a transparent substrate such as glass plate through an adhesive layer. In this optical filter for display, the opening parts of the mesh-shaped pretreatment layer and metal conductive layer are generally filled with the adhesive layer.

The optical filter for display may be provided with an antireflective layer, a color hue adjusting layer, a near-infrared cutting layer, in addition to the transparent substrate, light transmissive electromagnetic wave shielding layer (metal conductive layer) and adhesive layer. The order for superposing these layers are determined depending upon the intended purposes. Further, electrodes for connecting with earth terminals of a PDP main body can be provided on the optical filter in order to enhance electromagnetic wave shielding property.

### EXAMPLE

The present invention is illustrated in detail below using the following Examples. The invention is not restricted by the Examples.

### [Example 1]

(1) Preparation of fine particle having extremely-thin noble metal film
   An acrylic resin fine particle (mean particle size: 0.5 µm, Chemisnow MP, available from Soken Chemical & Engineering Co., Ltd.) was washed with a 5% sodium hydroxide aqueous solution, and immersed in hydrochloric acid (1N) to be neutralized. Subsequently, the resultant acrylic resin fine particle was immersed in an aqueous solution of palladium chloride (200mL/L) and tin chloride (200mL/L) at 30°C for two minutes, and then immersed in an aqueous solution of hydrochloric acid (100mL/L) at 30°C for two minutes. Thus, an acrylic resin fine particle having an extremely-thin film of Pd on its surface was obtained. The extremely-thin film had a thickness of 50nm, which was determined by an electron microscope.
(2) Preparation of pretreatment agent
   30 Parts by weight of the acrylic resin fine particle having extremely-thin Pd film and 100 parts by weight (solid content) of a two-component curable polyester resin solution (AD-335/CAT-10L (solid content of the mixture: 10% by weight), available from Toyo-Morton, Ltd.) were mixed with each other to form a pretreatment agent.
(3) Preparation of mesh-shaped pretreatment layer
   Subsequently, the pretreatment agent was printed in a mesh pattern on a PET film (the thickness of 100 µm) by gravure printing and dried at 120°C for five minutes, and thus a mesh-shaped pretreatment layer was formed on the PET film. The resultant pretreatment agent had a line width of 20 µm, the distance between the lines was 254 µm, and the opening ration was 85%. The thickness after drying was 0.15 µm.
(4) Preparation of metal conductive layer
   The resultant PET film having pretreatment layer was immersed in a sodium hypophosphite solution (30g/L) at 60°C for three minutes, and then immersed in an electroless plating solution (Melpate CU-5100, available from Meltex Co., Ltd) to be subjected to electroless plating treatment at 50°C for 20 minutes, whereby a mesh-shaped metal conductive layer was formed. The resultant metal conductive layer had a line width of 28 µm, the distance between the lines was 254 µm, and the opening ration was 79%. The thickness after drying was 4 µm.
(5) Blackening treatment of metal conductive layer
   Further, the PET film on which the metal conductive layer had been formed was subjected to a blackening treatment as follows.

The composition of the blackening treatment solution (aqueous solution)
Sodium chlorite: 10 wt.%
Sodium hydroxide: 4 wt.%
The conditions of the blackening treatment:
   Bath temperature: approx. 60°C
   Time period: five minutes
Thus, a light transmissive electromagnetic wave shielding material having the metal conductive layer whose surface was subjected to the blackening treatment was obtained. The thickness of the blackening treatment layer formed on the surface of the light transmissive electromagnetic wave shielding material was 0.5 µm on average.

### [Example 2]

The procedures of Example 1 were repeated except that (1) Preparation of fine particle having extremely-thin noble metal film was carried out as below and that the immersing treatment of the resultant PET film having pretreatment layer in a sodium hypophosphite solution (30g/L) was not carried out to form a light transmissive electromagnetic wave shielding material.
(1) Preparation of fine particle having extremely-thin noble metal film
   An acrylic resin fine particle (mean particle size: 0.5 µm, Chemisnow MP, available from Soken Chemical & Engineering Co., Ltd.) was washed with a 5% sodium hydroxide aqueous solution, and immersed in hydrochloric acid (1N) to be neutralized. Subsequently, the resultant acrylic resin fine particle was immersed in a coupling agent for fixation of palladium (PM-12, Pd concentration: 12mg/L; available from Nippon Mining & Metals Co., Ltd.) at 25°C for 10 minutes. Thus, an acrylic resin fine particle having an extremely-thin film of Pd on its surface was obtained. The extremely-thin film had a thickness of 10nm, and is thought of as approx. monomolecular film.

### [Reference Example 1]

The procedures of Example 1 were repeated except that (1) Preparation of fine particle having extremely-thin noble metal film was carried out as below to form a light transmissive electromagnetic wave shielding material.
(1) Preparation of fine particle having noble metal (palladium colloid)
   One part by weight of palladium chloride was dissolved in 89 parts by weight of purified water, and further 10 parts by weight of trisodium citrate dissolved in the purified water by stirring. Thereafter 0.01 part by weight of sodium borohydride was added to the resultant solution to reduce palladium chloride, whereby palladium colloid stabilized and colloidally protected by citric acid was obtained. Then the palladium colloid was concentrated and demineralizid by ultrafiltration to form palladium colloid containing 0.5 part by weight of palladium.

An acrylic resin fine particle (mean particle size: 0.5 µm, Chemisnow MP, available from Soken Chemical & Engineering Co., Ltd.) was washed with a 5% sodium hydroxide aqueous solution, and immersed in hydrochloric acid (1N) to be neutralized. Subsequently, the resultant acrylic resin fine particle was immersed in the palladium colloid obtained above at 25°C for 10 minutes. Thus, an acrylic resin fine particle having Pd particle on its surface was obtained.

In Reference Example 1, the resultant metal conductive layer had the same thickness as in Example 1. However, the amount of Pd used in Reference Example 1 was far more than that of Example 1.

### Industrial Applicability

According to the process of the present invention, a light transmissive electromagnetic wave shielding material enhanced in light transmissive property, electromagnetic wave shielding property, appearance and legibility can be obtained. The light transmissive electromagnetic wave shielding material is useful in an adhesive sheet which can be used for a front filter of a plasma display panel (PDP) or windows of a building such as a hospital requiring electromagnetic wave shielding.

## Claims

1. A process for the preparation of a light transmissive electromagnetic wave shielding material comprising;
printing in the form of mesh a pretreatment agent for electroless plating on a transparent substrate to form a mesh-shaped pretreatment layer, the pretreatment agent comprising a fine particle having an extremely-thin film of noble metal on its surface, and
subjecting the mesh-shaped pretreatment layer to electroless plating to form a mesh-shaped metal conductive layer on the pretreatment layer.

2. A process as defined in claim 1, wherein the extremely-thin film of noble metal has a thickness of 10 to 100 nm.

3. A process as defined in claim 1 or 2, wherein the extremely-thin film of noble metal comprises a monomolecular film of noble metal.

4. A process as defined in any of claims 1 to 3, wherein the fine particle is an organic resin fine particle.

5. A process as defined in claim 4, wherein the organic resin fine particle is a particle of phenol resin, amino resin, polyester resin, melamine resin, epoxy resin, divinylbenzene polymer, styrene/divinylbenzene copolymer, acrylic resin or styrene/(meth)acrylate copolymer.

6. A process as defined in claim 4 or 5, wherein the organic resin of the organic resin fine particle is crosslinked.

7. A process as defined in any of claims 1 to 6, wherein the fine particle has mean particle size of 0.05 to 3 µm.

8. A process as defined in any of claims 1 to 7, wherein the pretreatment agent further contains synthetic resin.

9. A process as defined in any of claims 1 to 8, wherein the noble metal is at least one metal selected from the group consisting of palladium, silver, platinum and gold.

10. A process as defined in any of claims 1 to 9, wherein the fine particle having an extremely-thin film of noble metal is obtained by treating the fine particle with a solution containing noble metal chloride and tin chloride, and subjecting the treated fine particle to reduction treatment.

11. A process as defined in any of claims 1 to 9, wherein the fine particle having an extremely-thin film of noble metal is obtained by treating the fine particle with a solution comprising a noble metal compound and a mixture of a silane coupling agent and an azole compound or a reaction product thereof

12. A process as defined in claim 11, wherein the silane coupling agent is an epoxy-containing silane compound.

13. A process as defined in claim 11 or 12, wherein the azole compound is imidazole.

14. A process as defined in any of claims 1 to 13, which further comprises drying the transparent substrate on which the pretreatment agent has been printed at 80 to 160°C.

15. A process as defined in any of claims 1 to 14, wherein metal used in the electroless plating is silver, copper or aluminum.

16. A light transmissive electromagnetic wave shielding material comprising a transparent substrate, a mesh-shaped pretreatment layer provided thereon, and a mesh-shaped metal conductive layer provided on the pretreatment layer,
wherein the pretreatment layer comprises a fine particle having an extremely-thin film of noble metal on its surface.

17. A light transmissive electromagnetic wave shielding material as defined in claim 16, wherein the extremely-thin film of noble metal has a thickness of 10 to 100 nm.

18. A light transmissive electromagnetic wave shielding material as defined in claim 16 or 17, wherein the fine particle is an organic resin fine particle.

19. A fine particle having an extremely-thin film of noble metal on its surface.

20. A fine particle as defined in claim 19, wherein the fine particle is an organic resin fine particle.
